## Europäisches Patentamt

## European Patent Office

## Office européen des brevets

(19)

(11) Veröffentlichungsnummer: **0 144 572**
**B1**

(12) **EUROPÄISCHE PATENTSCHRIFT**

(45) Veröffentlichungstag der Patentschrift:
**18.10.89**

(51) Int. Cl.⁴: **H 01 J 37/34**

(21) Anmeldenummer: **84110940.8**

(22) Anmeldetag: **13.09.84**

(54) **Magnetronkatode zum Zerstäuben ferromagnetischer Targets.**

(30) Priorität: **05.12.83 DE 3343904**

(43) Veröffentlichungstag der Anmeldung:
**19.06.85 Patentblatt 85/25**

(45) Bekanntmachung des Hinweises auf die Patenterteilung:
**18.10.89 Patentblatt 89/42**

(84) Benannte Vertragsstaaten:
**AT BE CH DE FR GB IT LI LU NL SE**

(56) Entgegenhaltungen:
**US-A- 4 391 697**
**US-A- 4 414 086**

**4ème COLLOQUE INTERNATIONAL SUR LES PLASMAS ET LA PULVERISATION CATHODIQUE, 13.-17. September 1982, Seiten 243-246, Nice, FR; C. MORRISON: "High rate sputtering of highly permeable materials"**

(73) Patentinhaber: **LEYBOLD AKTIENGESELLSCHAFT, Wilhelm-Rohn-Strasse 25, D-6450 Hanau am Main (DE)**

(72) Erfinder: **Alchert, Hans, Dr.-Ing., Westbahnhofstrasse 15, D-6450 Hanau am Main (DE)**
Erfinder: **Kukla, Reiner, Dipl.-Physiker, Pfortenwingert 2, D-6450 Hanau/Main 9 (DE)**
Erfinder: **Kieser, Jörg, Dr. Phys., Goldbergstrasse 4a, D-8755 Albstadt (DE)**

(74) Vertreter: **Zapfe, Hans, Dipl.-Ing., Am Eichwald 7, D-6056 Heusenstamm 2 Rembrücken (DE)**

## Beschreibung

Die Erfindung betrifft eine Magnetronkatode nach dem Oberbegriff des Patentanspruchs 1.

Magnetronkatoden mit ebenen oder gewölbten Zerstäubungsflächen sind hinreichend bekannt. Dabei wird eine räumlich definierte Anordnung von Permanent- und/oder Elektromagneten in einer solchen relativen Lage zur Zerstäubungsfläche vorgesehen, daß über der Zerstäubungsfläche ein ringförmig geschlossener Tunnel von Magnetfeldlinien erzeugt wird, durch den die den Zerstäubungsvorgang bewirkende Glimmentladung auf einen Bereich in unmittelbarer Nähe der Zerstäubungsfläche begrenzt und dadurch die Zerstäubungsrate um mehr als eine Zehnerpotenz erhöht wird. Mit «Zerstäubungsfläche» wird die der Glimmentladung ausgesetzte, wirksame Targetoberfläche bezeichnet, von der die zerstäubten Partikel ausgehen, in der Regel also die Targetvorderfläche (DE-AS 2 431 832).

Derartige Magnetronkatoden sind in mehreren Varianten bekannt geworden, die entweder eine begrenzte Anwendungsmöglichkeit haben und/ oder die in sie gesetzten Erwartungen nicht voll erfüllen. So werden bei der bekannten Ausführungsform die Polflächen des Magnetsystems hinter dem Target angeordnet, so daß die Mehrzahl der Magnetfeldlinien die Targetfläche zweimal durchdringt. Eine solche Bauweise ist jedoch für Targets aus magnetischen Werkstoffen, die z.B. für die Herstellung von magnetischen Aufzeichnungsbändern benötigt werden, entweder nicht oder nur in Verbindung mit zusätzlichen Maßnahmen brauchbar.

Diese Maßnahmen können beispielsweise darin bestehen, das Target sehr dünn auszubilden, so daß eine ausreichende Anzahl von Magnetfeldlinien das Target durchdringen kann. Eine solche Maßnahme setzt jedoch eine häufige Targeterneuerung voraus. Eine weitere Möglichkeit besteht darin, die Vorrichtung im magnetischen Sättigungsbereich des Targetmaterials zu betreiben, was jedoch außerordentlich starke Magnetsysteme voraussetzt, ohne daß es bisher gelungen wäre, die Verzerrungen des Magnetfeldes in den Griff zu bekommen, die sich mit zunehmendem Verbrauch des Targetmaterials ändern.

Weiterhin ist es möglich, das Targetmaterial auf eine Temperatur oberhalb des spezifischen Curie-Punktes zu erhitzen, so daß die magnetischen Feldlinien auch dickere Targetplatten durchdringen können. Die Curie-Temperaturen liegen je nach Targetmaterial zwischen etwa 400 und 1100 °C, so daß erhebliche thermische Probleme mit einer solchen Lösung verbunden sind. Es ist dabei auch bekannt, den Austritt der Feldlinien durch Nuten in der Targetfläche zu erleichtern (US-PS 4 299 678). Eine Unterteilung der Katodenvorderseite in Target und Polschuhe durch Luftspalte ist jedoch nicht vorgesehen, so daß die Wirkung begrenzt und auf die Unterstützung durch Temperaturerhöhung angewiesen ist.

Durch die US-PS 4 198 283 ist eine Magnetronkatode bekannt, bei der das aus mehreren Teilstücken bestehende Target zwischen weichmagnetischen Polschuhen eingespannt ist. Dadurch ist im wesentlichen die Bedingung erfüllt, daß sich die Projektionen von Targets und Polfläche in eine gemeinsame, zur Zerstäubungsfläche parallele Ebene nicht überschneiden. Durch die Art der Einspannung wird jeglicher Luftspalt parallel zu der genannten Ebene vermieden. Dadurch ist die Verwendung von Targets aus ferromagnetischen Werkstoffen ausgeschlossen, weil nämlich in einem solchen Fall die magnetischen Feldlinien aus den Polschuhen in Querrichtung in das Target eintreten würden, so daß es nicht mehr zur Ausbildung eines magnetischen Tunnels bzw. des Magnetroneffekts kommt.

Bei einer durch die DE-PS 3 012 935 bekannten Magnetronkatode liegen die Magnetpole entgegengesetzter Polarität zwischen gemeinsamen Ebenen und haben dabei jeweils einen endlosen, in sich geschlossenen länglich-runden Verlauf, der als konzentrisch bezeichnet werden kann. Die Magnetfeldlinien zwischen den inneren und den äußeren Polen durchdringen dabei den Abstand zwischen diesen Polen. Innerhalb dieses Abstandes ist ein geometrisch ähnliches, d.h. länglichrundes Target aus dem zu zerstäubenden Werkstoff angeordnet. Diese Anordnung ist jedoch ausschließlich für die Zerstäubung nicht-ferromagnetischen Materials geeignet. Die DE-PS 3 012 935 beschreibt auch die Möglichkeiten zur Zerstäubung ferromagnetischer Targets mit der Maßgabe, daß durch weitere Magnetvorrichtungen ein zweites Magnetfeld erzeugt wird. Dieses zweite Magnetfeld soll bezüglich des ersten Magnetfeldes und der Zerstäubungsfläche so verlaufen, daß die Neigung des ersten Magnetfeldes wesentlich reduziert wird, die magnetisch permeable Zerstäubungsfläche zu durchdringen. Diese Anordnung ist im Hinblick auf das zusätzlich benötigte Magnetsystem sehr aufwendig. Hinzu kommt, daß der Ausnutzungsgrad des plattenförmigen Targetmaterials extrem schlecht wäre, so daß die bekannte Lösung für ferromagnetisches Targetmaterial in Stangen- oder Stabform vorgesehen ist.

Die US-A-4 391 697 offenbart eine Magnetronkatode, bei der der eine Magnetpol hinter dem aus magnetischem Werkstoff bestehenden zentralen Teil des Targets angeordnet ist. Dieser zentrale Teil ist unter Belassung eines Luftspalts von einem peripheren Targetteil umgeben, das in gewissem Umfange die Funktion von Polschuhen hat. Soweit der periphere Targetteil räumlich vor dem zentralen Targetteil liegt, stehen sich im Luftraum vor dem zentralen Targetteil gleichnahmige Magnetpole gegenüber, so daß sich kein den zentralen Teil übergreifender geschlossener Tunnel aus Magnetfeldlinien ausbilden kann. Die Magnetfeldlinien können daher nur im Bereich des einen umlaufenden Luftspalts vom peripheren Targetteil in den zentralen Targetteil eintreten, wobei die maximale Zerstäubungswirkung ausgerechnet im Bereich des Luftspalts auftritt, in dessen Umgebung sich verhältnismäßig wenig Zerstäubungsmaterial befindet. Es muß sogar durch besondere Maßnahmen dafür Sorge getragen werden, daß nicht vom Boden des Luftspalts Material zerstäubt wird, das im Falle eines nicht-kompatiblen Werkstoffs die niedergeschlagenen Schichten verunreinigen würde. Mit einer derartigen Lösung kann im wesentlichen nur Material in unmittelbarer Nachbarschaft des Luftspalts zerstäubt werden, so daß der Materialausnutzungsgrad sehr gering ist. Die für eine flächige Abtragung des Targetmaterials schädliche, im Bereich des einzigen Luftspalts örtlich hohe Magnetfeldkonzentration wird durch unmittelbare Ankopplung der Targetteile an die Magnetpole über hochpermeable Bauteile sogar noch verstärkt.

Durch die DE-OS 3 244 691 ist eine Magnetronkatode der eingangs beschriebenen Gattung bekannt, bei der die Permanentmagnete auf einer Ebene angeordnet sind, die entweder durch die Zerstäubungsfläche des Targets gebildet wird oder in der die Zerstäubungsfläche zu Beginn des ersten Zerstäubungsvorganges liegt. Bei einer Variante dieses Prinzips liegen die Permanentmagnete in einer Ebene, in der sich die Targetrückseite befindet. In allen Fällen befinden sich die Permanentmagnete in einer Zone höchster thermischer Belastung. Da speziell die heutigen Hochleistungs-Magnetwerkstoffe bereits in einem mit Magnetronkatoden leicht erreichbaren Temperaturbereich zwischen 150 und 200 °C ihre magnetischen Eigenschaften verlieren, wird in der bekannten Schrift angegeben, daß die beschriebene Anordnung äußerst wirksam zu kühlen ist. Da die Permanentmagnete im Hinblick auf die vorgeschriebene Magnetisierungsrichtung eine bestimmte axiale Länge von etwa 8 bis 10 mm nicht unterschreiten können, andererseits aber das Zerstäuben des Magnetwerkstoffs selbst oder seitlich davon angebrachter nicht-ferromagnetischer Blöcke unbedingt unterbleiben muß, dürfen die an dieser Stelle vorhandenen Luftspalte eine Spaltweite von etwa 1 bis 2 mm nicht überschreiten. Die Kleinhaltung dieser Luftspalte ist aber im Hinblick auf die notwendige Länge der Permanentmagnete nur dadurch möglich, daß die Polschuhe an ihren Innenkanten mit kragenförmigen Fortsätzen versehen sind. Die an den Kragenenden austretenden Feldlinien werden auf einem sehr kurzen Wege in das Targetmaterial gelenkt, aus dem sie, dem Weg des geringsten Widerstandes folgend, wieder in die Gegenpole der Permanentmagnete eintreten, da das ferromagnetische Target, die ferromagnetische Stützplatte und die Permanentmagnete ohne Luftspalte direkt aufeinander sitzen. Die Folge ist eine enge Begrenzung der «magnetischen Falle», so daß anstelle einer an sich wünschenswerten flächigen Abtragung des Targetmaterials zwei grabenförmige Erosionszonen unterhalb der Kragenränder die Folge sind. Durch die Anordnung der Kragen verteuert sich der Herstellungsprozeß wesentlich, was insofern von Nachteil ist, als die Polschuhe selbst am Zerstäubungsprozeß teilnehmen, so daß nur eine geringe Standzeit die Folge ist.

Einerseits sind Magnetronkatoden wegen ihrer hohen spezifischen Zerstäubungsleistung sehr beliebt, andererseits ist der Ausnutzungsgrad des Targetmaterials aufgrund des Magnetron-Prinzips sehr schlecht. Das Plasma erzeugt nämlich insbesondere im Kulminationsbereich der magnetischen Feldlinien tiefe Erosionsgräben, die das Tagert vorzeitig unbrauchbar werden lassen. Man hat bereits auf Abhilfe durch Verbreiterung der Erosionsgräben gesonnen: Durch die DE-PS 2 556 607 ist es bekannt, den Verlauf der Magnetfeldlinien durch Überlagerung eines zweiten oszillierenden Magnetfeldes periodisch zu verlagern. Durch die DE-OS 2 707 144 ist es zum gleichen Zwecke bekannt geworden, das Magnetsystem parallel zur Zerstäubungsfläche periodisch zu verschieben. Schließlich ist es durch die DE-OS 3 004 546 zur Verbesserung des Ausnutzungsgrades des Targetwerkstoffs bereits bekannt, bei einer rotationssymmetrischen Magnetronkatode zusätzlich zu dem Hauptmagnetsystem noch mehrere Hilfsmagnetsysteme anzuordnen, durch die die nach außen abnehmende Dichte der Feldlinien des Hauptmagnetsystems kompensiert werden soll. Sämtliche zuvor beschriebenen Maßnahmen sind jedoch nur bei Targets aus nicht-ferromagnetischen Werkstoffen brauchbar, da bei ferromagnetischen Werkstoffen die Magnetfeldlinien das Material von Targets mit wirtschaftlich hinreichender Dicke nicht durchdringen können.

Der Erfindung liegt daher die Aufgabe zugrunde, eine Magnetronkatode der eingangs beschriebenen Gattung dahingehend zu verbessern, daß mit ihr ferromagnetische Targetwerkstoffe, wirtschaftlich, d.h. mit hoher spezifischer Zerstäubungsleistung und bei hoher Materialausnutzung zerstäubt werden können.

Die Lösung der gestellten Aufgabe erfolgt bei der Magnetronkatode nach dem Oberbegriff des Patentanspruchs 1 erfindungsgemäß durch die im Kennzeichen des Patentanspruchs 1 angegebenen Merkmale.

Der Abstand «S» ist nicht unbedingt der Gesamtabstand zwischen der Unterseite der Polschuhe und den Magnetpolen (in diesem Gesamtabstand können sich beispielsweise zum Teil ferromagnetische Fließführungskörper befinden), sondern ein außerhalb ferromagnetischer Werkstoffe befindlicher «Spalt».

Hierbei ist von Bedeutung, daß zwischen den einander gegenüberliegenden Austrittsflächen der Polschuhe und dem Target zwei Luftspalte gebildet werden, die sich in Tiefenrichtung der Anordnung erstrecken. Dabei ist das Target gegenüber den Polschuhen in Richtung auf die Basis des Jochs zurückgesetzt angeordnet, so daß der überwiegende Teil der Magnetfeldlinien über der Zerstäubungsfläche aus den Polschuhen austritt. Diese Maßnahme ist in unmittelbarem Zusammenhang mit der Maßnahme im Oberbegriff zu sehen, daß sich die Projektionen der Magnetpole und des Targets in einer zur Zerstäubungsfläche parallelen Ebene nicht überschneiden, so daß auch an dieser Stelle Luftspalte gebildet werden.

Von Bedeutung ist hierbei gleichfalls, daß sich im Gegensatz zur US-A-4 391 697 – im Luftraum vor dem ringförmigen Target bzw. vor den beiden Luftspalten entgegengesetzte Magnetpole gegenüberliegen, so daß die Magnetfeldlinien auch eine «Brücke» über das Target bilden können. Es ist also nicht so, und dies steht im Gegensatz zur DE-OS 3 244 691, daß die Magnetfeldlinien auf einem relativ kurzen Wege jenseits des jeweils überbrückten Luftspalts wieder in das Target eintreten, aus dem sie mit geringem magnetischen Widerstand wieder in die Gegenpole der Permanentmagnete fließen. Vielmehr wird dieser Weg mit einem möglichst hohen magnetischen Widerstand ausgestattet, indem das Target und die Magnetpole so angeordnet sind, daß sich ihre Projektionsflächen in einer zur Zerstäubungsfläche parallelen Ebene nicht überschneiden, sondern in besonders vorteilhafter Ausführung sogar mit Abständen «x» ineinander liegen und daß keine magnetische hochleitfähige Verbindung zwischen Target und Magneten besteht.

Der Abstand «S» zwischen den Polschuhen und den Magnetpolen erfüllt in der erfindungsgemäßen Anordnung zwei sehr wichtige Funktionen.

1. bewirkt er die thermische Entkopplung der hitzeempfindlichen Permanentmagnete vom heißen Sputtertarget und ermöglicht dadurch sehr hohe Leistungsdichten und dadurch wiederum sehr hohe Sputterraten.

2. wirkt er als Luftspalt, und zwar auch dann, wenn der Abstand «S» ganz oder teilweise mit einem nicht-ferromagnetischen Medium wie beispielsweise Kupfer, ausgefüllt sein sollte. Dadurch tritt nicht der gesamte magnetische Fluß in die Polschuhe ein, sondern es entsteht eine Streuwirkung. Ein Teil der magnetischen Feldlinien tritt in die Polschuhe ein, ein weiterer Teil in die Seitenflächen des Targets. Dies hat folgenden Effekt:

Durch die relative Dimensionierung der Luftspalte, die in Richtung auf die Basis des Jochs und in Querrichtung hierzu angeordnet sind, läßt sich der Anteil des durch das Target verlaufenden magnetischen Flusses zu dem Anteil des über das Target verlaufenden Flusses («Brücke») variieren. Die Richtung auf die Basis des Jochs kann auch als «Tiefenrichtung» bezeichnet werden. Die genannte Dimensionierung hat wiederum einen unmittelbaren Einfluß auf die geometrische Form der magnetischen Feldlinien und damit der Plasmafalle sowie der flächenmäßigen Verteilung des Targetverbrauchs. Wie noch anhand der Detailbeschreibung näher aufgezeigt werden wird, lassen sich die Verhältnisse leicht optimieren, so daß die Zerstäubungsfläche auch bei fortschreitendem Verbrauch des Targetmaterials angenähert eben bleibt, so daß eine den Stand der Technik weit übertreffende Targetausnutzung von über 50% die Folge ist.

Durch die Unterbringung der Magnetpolschuhe in Tiefenrichtung der Anordnung hinter der Zerstäubungsfläche des Targets, insbesondere durch die Unterbringung der Magnetpole hinter dem wärmeleitenden Metallkörper, auf dessen Vorderseite sich Target und Polschuhe befinden, wird erreicht, daß das Magnetsystem nicht nur nicht im Bereich hoher thermischer Belastung angeordnet ist, sondern sogar durch einfache Maßnahmen sehr viel intensiver gekühlt werden kann. Dadurch werden der Auswahl magnetischer Werkstoffe keine Grenzen gesetzt.

Weiterhin ist es nicht erforderlich, die Polschuhe im Hinblick auf die Tiefenerstreckung der Permanentmagnete mit Kragen zu versehen, so daß sich die Herstellung der Polschuhe durch Heraustrennen aus einem plattenförmigen Werkstoff entsprechend billig gestaltet. Dadurch entfällt gleichzeitig die unerwünschte Leitwirkung der kragenförmigen Vorsprünge auf den magnetischen Fluß.

Mittels der erfindungsgemäßen Magnetronkatode lassen sich dicke Targets aus ferromagnetischen Werkstoffen zerstäuben. Diese Möglichkeit ist insbesondere deswegen gegeben, weil eine magnetische Sättigung des Targetmaterials nicht erforderlich ist. Damit verbunden ist eine extrem große Standzeit der Magnetronkatode bis zum Targetwechsel. Dennoch ist eine hohe Zerstäubungsgeschwindigkeit möglich, wie diese bei dikken ferromagnetischen Targets ohne Anwendung der erfindungsgemäßen Vorrichtung nicht möglich wäre.

Weitere vorteilhafte Ausgestaltungen des Erfindungsgegenstandes sind in den Unteransprüchen beschrieben und in der Detailbeschreibung näher erläutert.

Ausführungsbeispiele des Erfindungsgegenstandes werden nachfolgend anhand der Figuren 1 bis 11 näher erläutert.

Es zeigen:

Fig. 1 einen schematischen Axialschnitt durch die wesentlichen Teile des Magnetrons,

Fig. 2 und 3 Draufsichten auf verschiedene Formen des Magnetrons und ihre Variationsmöglichkeiten,

Fig. 4 einen Axialschnitt analog Fig. 1, jedoch in Vereinigung mit weiteren Bauteilen, d.h. ein spezielles Ausführungsbeispiel,

Fig. 5 einen schematischen Axialschnitt analog der linken Hälfte von Fig. 1 durch ein Magnetron mit einer Variante, bei der die Magnetpole die Polschuhe außen umgeben,

Fig. 6 einen schematischen Axialschnitt analog Fig. 5, jedoch mit negativer Überlappung «d», und

Fig. 7 einen schematischen Axialschnitt analog Fig. 6, jedoch mit umgekehrter Anordnung von Permanentmagneten,

Fig. 8 einen Axialschnitt durch eine Variante des des Magnetrons nach Fig. 4, bei dem der wärmeleitende Metallkörper zwischen dem Target und dem Magnetsystem als ebene Platte ausgeführt ist,

Fig. 9 einen Teilausschnitt aus der linken Hälfte von Fig. 8 in vergrößertem Maßstab zusammen mit einem Diagramm, in dem die Horizontalkomponente ($H_x$) der magnetischen Feldstärke im Abstand von 2 mm über der Polschuhoberfläche dargestellt ist, und zwar in Zuordnung zu den radialen Abmessungen des Magnetrons,

Fig. 10 eine Darstellung analog Fig. 9, jedoch mit einem eingezeichneten «Erosionsprofil» (= gestrichelte Linie), und

Fig. 11 die Betriebskennlinie des Magnetrons nach Fig. 8.

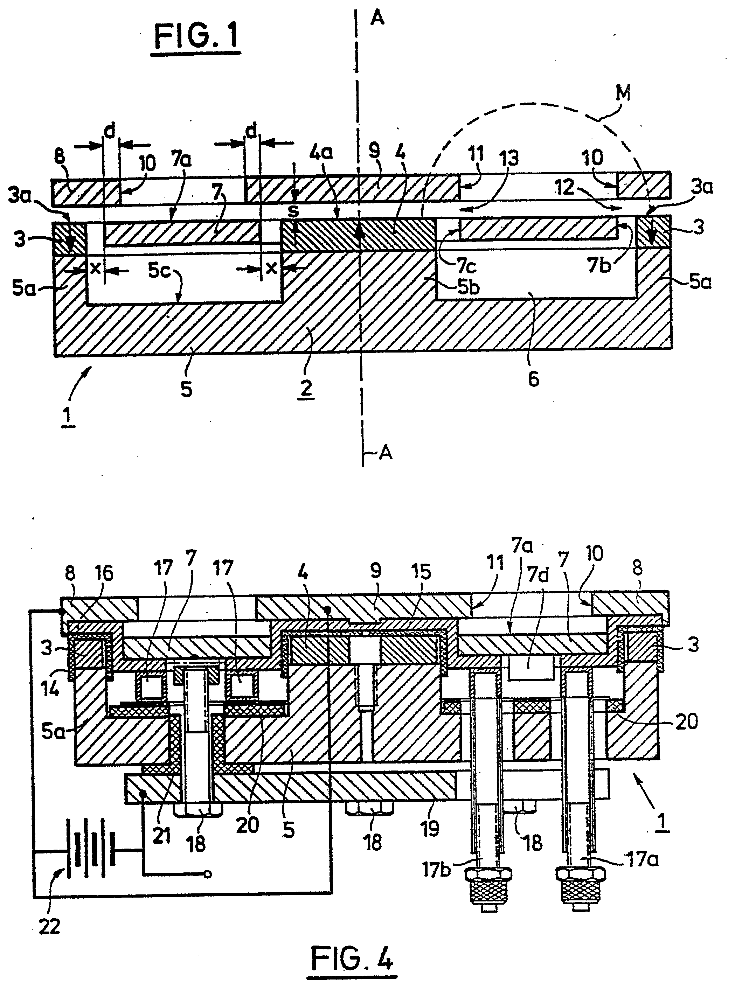

In Fig. 1 ist eine Magnetronkatode mit einem Katodengrundkörper 1 dargestellt, dessen wesentlicher Teil ein Magnetsystem 2 ist. Unter dem Ausdruck «Katodengrundkörper» ist derjenige Teil der Katode zu verstehen, der eine tragende Funktion für die übrigen Bauteile hat und mit dem die Katode innerhalb einer nicht gezeigten Vakuumkammer befestigt ist. Das Magnetsystem besteht aus einer definierten Anordnung von Permanentmagneten 3 und 4, die auf ihrer Rückseite ohne Zwischenschaltung eines Luftspalts mit einem Magnetjoch 5 verbunden sind. Die Magnetisierungsrichtung ist durch die Pfeile in den Permanentmagneten angedeutet, und es ist erkennbar, daß die Permanentmagnete 3 und 4 eine zueinander entgegengesetzte Magnetisierungsrichtung aufweisen, die in Richtung der Schenkel 5a und 5b des Magnetjochs 5 verläuft. Dadurch werden Magnetpole 3a und 4a gebildet, die in einer gemeinsamen Ebene verlaufen.

Die Permanentmagnete 3 bilden dabei ein auf dem Umfang zusammenhängendes System, das bevorzugt aus einzelnen Permanentmagneten zusammengesetzt sein kann. Die Permanentmagnete 3 liegen bei einem rotationssymmetrischen System, dessen Achse A–A bezeichnet ist, in dichter Aneinanderreihung auf dem Umfang einer Kreisringfläche, die durch die Oberseite des Schenkels 5a gebildet wird.

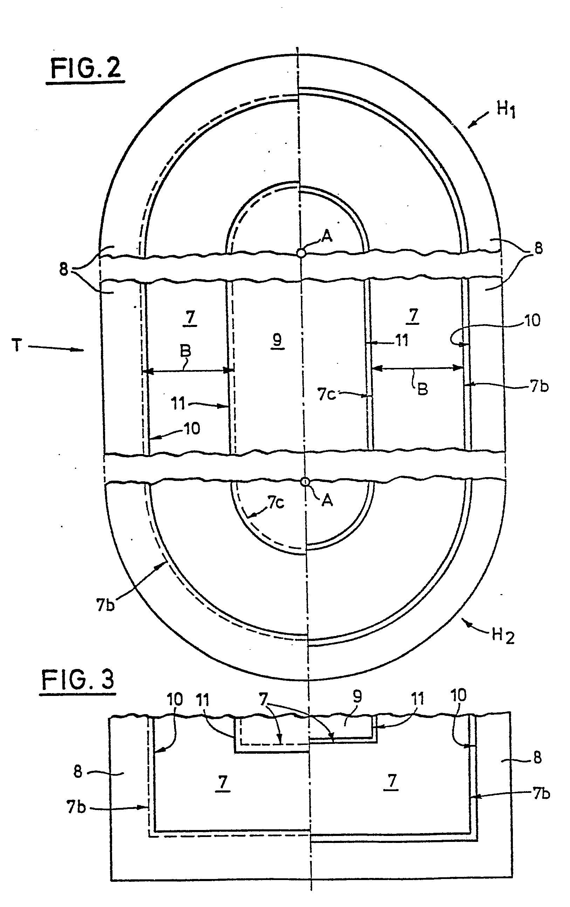

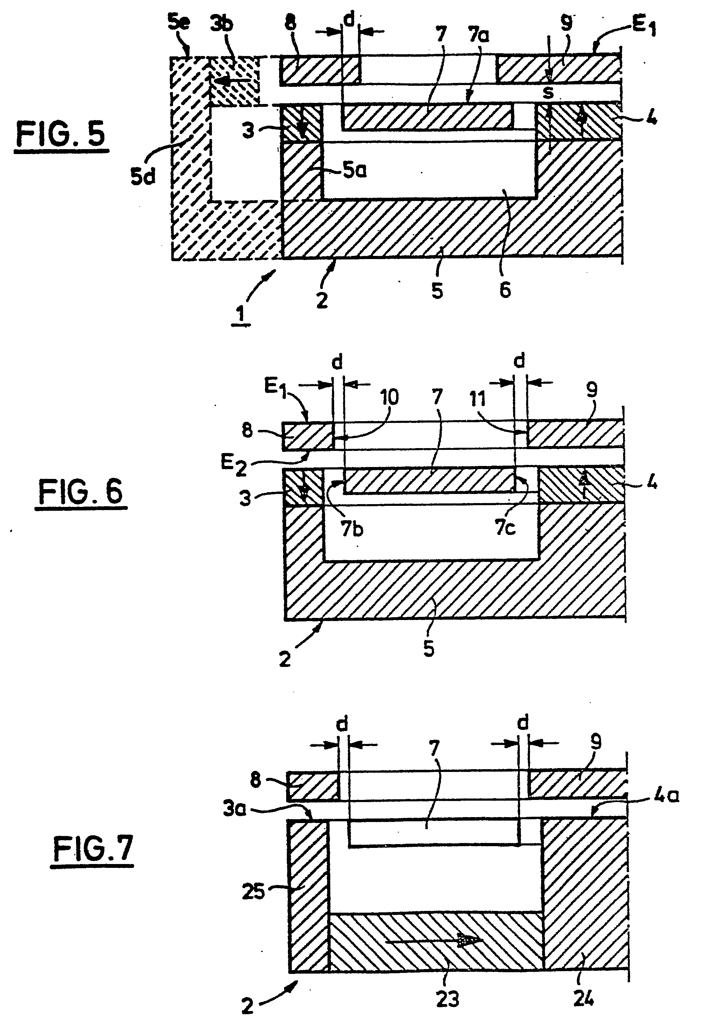

Es wird anhand der Fig. 2 und 3 noch aufgezeigt werden, daß die Erfindung nicht auf ein rotationssymmetrisches System beschränkt ist, sondern auch bei sogenannten ovalen oder Rechteckkatoden angewandt werden kann. Zur Vereinfachung der Beschreibung werden jedoch die nachfolgenden Erläuterungen anhand eines rotationssymmetrischen Systems gegeben.

Das Magnetjoch 5 hat im Querschnitt die Form eines «E», ist jedoch topfförmig ausgebildet. Auf der oberen Stirnfläche des Schenkels 5b ruht der Permanentmagnet 4, der aus einem Stück in Form eines gedrungenen Zylinders bestehen kann. (Bei einer langgestreckten Ausführung gemäß Fig. 2 kann jedoch auch der innere Permanentmagnet 4 aus mehreren Teilstücken identischer Magnetisierungsrichtung zusammengesetzt sein).

Auf die angegebene Weise bilden die Magnetpole 3a und 4a eine auf dem Umfang zusammenhängende Anordnung, die im Fall von Fig. 1 konzentrisch ausgebildet ist. Es liegen sich also innen und außen Magnetpole entgegengesetzter Polarität gegenüber, wobei im Falle der Abwesenheit ferromagnetischer Werkstoffe in der Nähe der Magnetpole Feldlinien senkrecht aus dem einen Magnetpol austreten und nach Durchlaufen einer bogenförmigen Bahn in den jeweils anderen Magnetpol wieder eintreten. Eine solche Feldlinie ist in Fig. 1, rechts, dargestellt und mit «M» bezeichnet. Bei Anwesenheit von ferromagnetischen Werkstoffen im Bereich der Magnetpole sind die Verhältnisse jedoch grundlegend anders.

Zwischen den Permanentmagneten 3 und 4 bzw. den damit fluchtenden Schenkeln 5a und 5b liegt ein hohlzylindrischer Raum 6, der nach unten hin durch die obere Kreisringfläche 5c des Magnetjochs 5 gebildet wird. In diesem Raum 6 liegt unter Wahrung zweier seitlicher Abstände «x» ein ebenfalls kreisringförmiges Target 7, das auch aus Teilstücken zusammengesetzt sein kann. Aus Teilstücken zusammengesetzte Permanentmagnete und Targets werden in jedem Falle als «auf dem Umfang zusammenhängend» bezeichnet. Die zu Beschichtungszwecken wirksame Fläche des Targets 7 ist dessen nach oben bzw. außen gerichtete Zerstäubungsfläche 7a.

Aufgrund der gewählten Anordnung bzw. der Einhaltung der Abstände «x» ist die Bedingung erfüllt, daß sich Magnetpole 3a und 4a sowie Target 7 in einer zur Zerstäubungsfläche 7a parallelen Ebene nicht überschneiden, sondern mit den genannten Abständen «x» ineinanderliegen.

Es ist im vorliegenden Falle wesentlich, daß das Target 7 aus einem ferromagnetischen Werkstoff besteht. Dies hätte ohne das Vorhandensein von magnetischen Polschuhen zur Folge, daß die magnetischen Feldlinien auf dem kürzest möglichen Wege in das Target 7 eindringen, so daß über diesem nicht der gewünschte, von nicht-ferromagnetischen Targets her bekannte Feldlinienverlauf erzielt werden kann, wie er in Fig. 1, rechts, durch die gestrichelte Linie «M» dargestellt ist. Damit aber kann sich ein sogenannter Magnetroneffekt nicht ausbilden, so daß auch nur die übliche, sehr niedrige Zerstäubungsrate erreicht würde, wie sie von sogenannten Dioden-Systemen her bekannt ist.

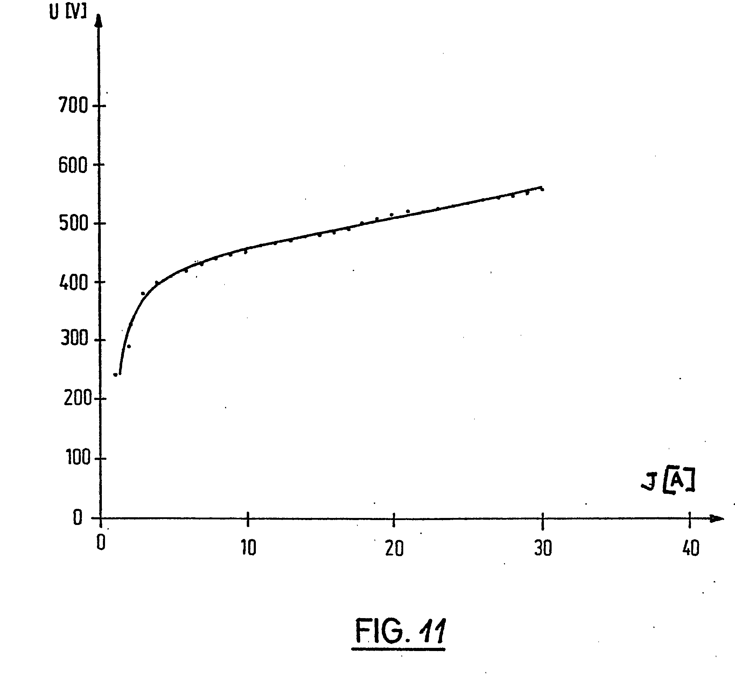

Erfindungsgemäß sind nun den Magnetpolen 3a und 4a Polschuhe 8 und 9 zugeordnet, deren Projektionsflächen in eine zur Zerstäubungsfläche 7a parallele Ebene eine Kreisringfläche bzw. eine Kreisfläche sind. Diese Polschuhe 8 und 9 bestehen zumindest teilweise, d. h. an ihren nach oben bzw. außen gerichteten Oberflächen aus dem gleichen Material wie das Target 7, sind also ferromagnetisch. Die Polschuhe unterliegen nämlich – wenn auch geringfügig – einem Zerstäubungsvorgang im Bereich ihrer Austrittsflächen (Fig. 10), so daß sich das Material der Polschuhe gleichfalls auf den Substraten niederschlägt. Durch die Materialidentität ist hiermit jedoch keineswegs ein Nachteil verbunden. Im günstigsten Fall können Target und Polschuhe aus ein und derselben Platte ferromagnetischen Materials hergestellt werden, beispielsweise durch Stanzen oder Ausbrennen, so daß eine optimale Materialausnutzung möglich ist. Mit dem Zerstäuben der Polschuhe ist jedoch im Laufe der Zeit keine Verlagerung der Austrittsflächen verbunden. Es wurde nämlich beobachtet, daß die Zerstäubung der Austrittsflächen weitgehend dadurch kompensiert wird, daß vom Target abgestäubtes Material auf den Austrittsflächen der Polschuhe niedergeschlagen wird, so daß ein Schutz der Polschuhe durch ein dynamisches Gleichgewicht zwischen Abstäuben und Aufstäuben eintritt.

Die Anordnung der Polschuhe 8 und 9 erfolgt in einem Abstand «s» zu den Magnetpolen 3a und 4a, so daß an dieser Stelle eine Eingriffsmöglichkeit für die magnetische Optimierung des Systems gegeben ist. Es hängt nämlich u.a. vom Verhältnis der Abstände x:s ab, welcher Anteil der Magnetfeldlinien von den Magnetpolen 3a bzw. 4a in das Target und welcher Anteil in die Polschuhe 8 und 9 eintritt. Größenordnungsmäßig wird man x=s wählen, wobei beide Abstände im Bereich weniger Millimeter liegen. Vergrößert man den Abstand «s», so dringt ein größerer Anteil des insgesamt von den Permanentmagneten zur Verfügung gestellten magnetischen Flusses an den Rändern des Targets 7 in dieses ein. Verkleinert man hingegen den Abstand «s», so nimmt der Anteil des Flusses zu, der von den Polschuhen 8 und 9 geführt wird.

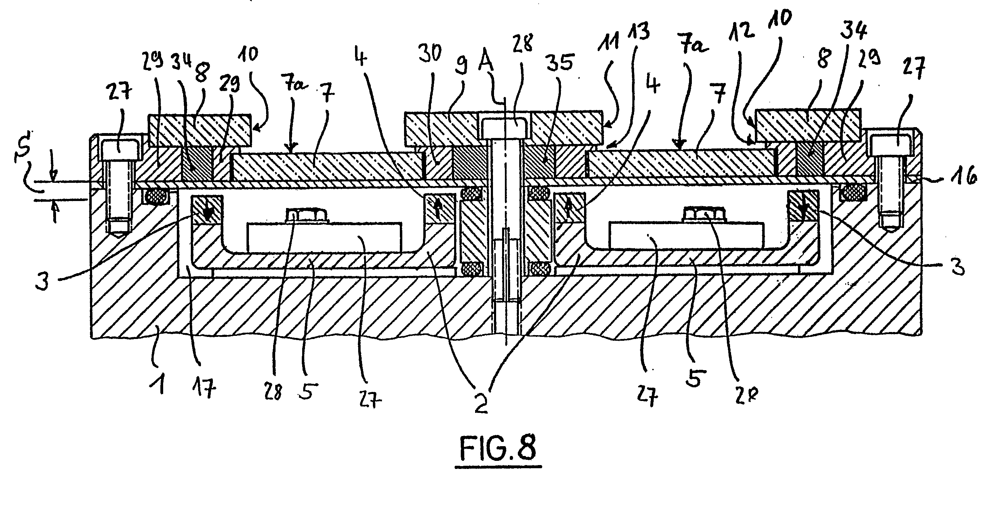

Im vorliegenden Falle liegt die Zerstäubungsfläche 7a in der gleichen Ebene wie die Oberflächen der Magnetpole 3a und 4a. Es sind aber Abweichungen von dieser Lage möglich, die gleichfalls zu einer Optimierung des Systems benutzt werden können (Fig. 8 bis 10).

Unter Optimierung wird eine Auslegung des Systems im Hinblick auf eine möglichst große Zerstäubungsrate bei gleichzeitiger möglichst gleichförmiger Abtragung des Targetmaterials von der Zerstäubungsfläche 7a verstanden. Ob diese Forderungen erfüllt werden, läßt sich durch verhältnismäßig einfache Versuche feststellen: Man zerstäubt ein Target 7 über mehrere Stunden oder Tage und mißt dann die restliche Geometrie des Targets 7. Durch die vorstehend beschriebene Veränderung der Abstände «x» und «s» relativ zueinander ist eine Korrektur im aufgezeigten Sinne möglich.

Eine weitere Einflußgröße für die Optimierung des Systems ist das Maß der Überlappung «d». Die Überlappung kann dabei positiv sein wie in Fig. 1, links gezeigt, d.h. die Projektionsflächen auf eine gemeinsame, zur Zerstäubungsfläche 7a parallele Ebene überschneiden sich. Die Überlappung kann aber auch d=0 sein, wie in Fig. 1, rechts, gezeigt; die Überlappung «d» kann aber auch negativ sein, wie dies in den Fig. 6 und 7 gezeigt ist, d.h. die genannten Projektionsflächen überschneiden sich nicht nur nicht, sie halten auch Abstände voneinander ein. Der in den Fig. 6 und 7 gezeigte Fall einer negativen Überlappung, selbst wenn sie nur ganz geringfügig ist, hat den Vorteil, daß das Target, welches sich wesentlich rascher verbraucht als die Polschuhe, ohne Demontage der Polschuhe ausgewechselt werden kann, wodurch die Stillstandszeiten der Vorrichtung drastisch verkürzt werden.

Aufgrund der in Fig. 1 dargestellten Anordnung besitzen die Polschuhe 8 und 9 Austrittsflächen 10 und 11, die auf dem Umfang in sich geschlossen sind, und deren gedachte Erzeugende senkrecht zur Zerstäubungsfläche 7a verläuft. Der Verlauf der Austrittsflächen auf ihrem Umfang ist zum Verlauf der Magnetpole und der Targetränder geometrisch ähnlich, d.h. die Abstände «x» sowie das Maß der positiven oder negativen Überlappung «d» sind auf dem gesamten Umfang gleich. Weiterhin existieren auf jeder Seite der Achse A-A in Tiefenrichtung der Anordnung zwischen dem Target 7 und dem Polschuh 8 einerseits sowie zwischen dem Target 7 und dem Polschuh 9 die beschriebenen zwei Luftspalte 12 und 13, durch die der magnetische Fluß gezwungen ist, zumindest teilweise aus den Austrittsflächen 10 und 11 auszutreten und den weiter oben beschriebenen Verlauf zu nehmen.

Das Target 7 besitzt auf beiden Seiten der Zerstäubungsfläche 7a zwei zylindrische und daher umlaufende Seitenflächen 7b und 7c, die im allgemeinen den beschriebenen geometrisch ähnlichen Verlauf haben, im Sonderfall gemäß Fig. 1, rechts, in der Projektion auf eine zur Zerstäubungsfläche 7a parallele Ebene jedoch zu den Austrittsflächen 10 und 11 kongruent sind.

Anhand von Fig. 2 sind – in der Draufsicht auf die Zerstäubungsfläche des Targets 7 Ausschnitte aus Magnetronkatoden mit verschiedenen geometrischen Formen dargestellt. Die Targetbreite ist dabei jeweils mit «B» durch einen Doppelpfeil angegeben. In der linken Hälfte haben Target 7 und Polschuhe 8 bzw. 9 eine positive Überlappung «d» gemäß Fig. 1, links und Fig. 5. Infolgedessen sind die Seitenflächen 7b und 7c des Targets verdeckt und nur gestrichelt dargestellt. Im rechten Teil der Fig. 2 liegt zwischen Target 7 und den Polschuhen 8 und 9 eine negative Überlappung gemäß den Fig. 6 und 7 vor, so daß die Seitenflächen 7b und 7c ebenso sichtbar sind, wie die Austrittsflächen 10 und 11. Diese Art der Darstellung gilt auch für Fig. 3.

In Fig. 2 ist oben und unten jeweils die Hälfte $H_1$ und $H_2$ einer Magnetronkatode nach Fig. 1 dargestellt, d.h. die Vereinigung der beiden Hälften $H_1$ und $H_2$ führt zu einem rotationssymmetrischen Magnetron mit der gemeinsamen Achse A-A nach Fig. 1. Setzt man zwischen die beiden Hälften $H_1$ und $H_2$ ein geradliniges Teil T ein, bei dem sämtliche Seitenflächen, Austrittsflächen und Luftspalte stufenlos in die entsprechenden Teile der rotationssymmetrischen Hälften einmünden, so ergibt sich eine langgestreckte Magnetronkatode nahezu beliebiger Längenabmessungen. Derartige Magnetronkatoden lassen sich mit Längen von etwa 4 m herstellen, so daß mit ihnen auch die Beschichtung von großflächigen Substraten wie beispielsweise Architekturglas möglich ist. Der Verlauf des durch die Magnetfelder eingefangenen Plasmas entspricht dabei dem Verlauf des Targets 7, so daß für den geschlossenen Bereich, in dem sich das Plasma ausbildet, auch der Begriff «Rennbahn» verwendet wird.

Es ist jedoch nicht erforderlich, die Enden einer langgestreckten Magnetronkatode analog Fig. 2 rotationssymmetrisch auszubilden, sondern man kann diese Enden auch rechteckig ausbilden, wie dies in Fig. 3 dargestellt ist.

In Fig. 4 sind gleiche Teile wie in Fig. 1 mit gleichen Bezugszeichen versehen. Es ist zu erkennen, daß das Magnetsystem 2, insbesondere die Permanentmagnete 3 und 4 mit Isolierstoffumhüllungen 14 und 15 umgeben ist, die eine Potentialtrennung zwischen Target 7 und Polschuhen 8/9 einerseits und dem Katodengrundkörper 1 andererseits bewirken sollen. Zwischen den Polschuhen 8 und 9 sowie dem Target 7 einerseits und den Magnetpolen 3a und 4a mit dem Magnetjoch 5 andererseits ist schließlich noch ein wärmeleitender Metallkörper 16 angeordnet, der mit einem Kühlmittelkanal 17 verbunden ist. Der Kühlmittelkanal 17 besteht aus einem bifilar gewundenen Vierkantrohr, welches flächig auf den Metallkörper 16 aufgelötet ist. Der Metallkörper ist – wie gezeichnet – im Querschnitt mäanderförmig ausgebildet, so daß die weiter oben beschriebenen Abstände bzw. Luftspalte eingehalten werden. Unter «Luftspalte» werden auch solche Abstände innerhalb des Magnetsystems verstanden, die durch nicht-ferromagnetische Werkstoffe ausgefüllt sind, wie beispielsweise durch die Isolierstoffumhüllungen 14/15 und den Metallkörper 16, der beispielsweise aus Aluminium, Kupfer oder amagnetischem Stahl bestehen kann.

Da sich das Target 7 sowie die Polschuhe 8/9 auf einem relativ hohen Potential befinden und mit dem Metallkörper in elektrisch leitender Verbindung stehen, müssen die beiden Anschlußenden 17a und 17b des Kühlmittelkanals 17 mit entsprechendem Isolationsabstand durch den Katodengrundkörper 1 hindurchgeführt werden.

Das Target 7 wird zusammen mit dem Metallkörper 16 und dem Kühlmittelkanal 17 durch mehrere auf den Umfang verteilte Zugschrauben 18 gegen den Katodengrundkörper 1 verspannt. Dies geschieht unter Zwischenschaltung einer Druckplatte 19, die gleichzeitig zum (nicht gezeigten) Anschluß für die Katodenspannung dient. Die erforderliche Spannungsisolierung erfolgt durch zwischengelegte Isolierkörper 20 und 21. Zum Unterschied von Fig. 1 besitzt das Target 7 auf seiner Rückseite mehrere Buchsen 7d, die je ein Gewinde für die Zugschrauben 18 tragen.

Obwohl Target 7 und Polschuhe 8 bzw. 9 im allgemeinen auf dem gleichen Potential liegen (Katodenpotential), ist es möglich, zwischen Target einerseits und Polschuhen andererseits auch noch eine Potentialdifferenz (Relativspannung) vorzusehen. Zu diesem Zweck ist zwischen der Druckplatte 19, an die die Hauptversorgungsspannung gelegt ist, und den Polschuhen 8 bzw. 9 noch eine weitere Spannungsquelle 22 angeordnet, die die gewünschte Potentialdifferenz zwischen 10 und 100 Volt, positiv oder negativ erzeugt. Es versteht sich, daß in diesem Fall Target 7 und Polschuhe 8/9 voneinander isoliert werden müssen. Dies kann auf einfache Weise durch Zwischenschaltung weiterer Isolierkörper geschehen, die an geeigneten Stellen auf dem Metallkörper 16 aufliegen, die in Fig. 4 nicht gesondert angedeutet sind.

Fig. 5 zeigt in ausgezogenen Linien eine Anordnung, die mit derjenigen in Fig. 1, linke Hälfte, übereinstimmt. Es ist jedoch links außen eine Variante dargestellt, die folgendes zum Gegenstand hat: Das Magnetjoch 5 ist bei unveränderten Abmessungen der Polschuhe 8/9 radial vergrößert und weist auch in axialer Richtung einen längeren Schenkel 5d auf, dessen Kreisringfläche 5e in der gleichen Ebene $E_1$ liegt, in der auch die oberen Begrenzungsflächen der Polschuhe 8/9 liegen. An diesen (umlaufenden) Schenkel 5d ist nun radial einwärts ein Magnet 3b angesetzt, der dem Magneten 3 entspricht, jedoch der äußeren Zylinderfläche des Polschuhs 8 gegenüberliegt. Hierdurch wird der Abstand zum Target 7 größer, so daß ein größerer Anteil des magnetischen Flusses in den Polschuh 8 eintritt. Die Überlappung «d» ist in Fig. 5 positiv.

Fig. 6 zeigt eine analoge Anordnung, jedoch mit dem Unterschied, daß in diesem Fall die Überlappung «d» negativ ist, wie dies bereits weiter oben beschrieben wurde. Eine solche Maßnahme erleichtert, wie gleichfalls bereits weiter oben beschrieben wurde, den Ausbau des Target 7, da dies nach oben durch den Zwischenraum zwischen den Polschuhen 8 und 9 hindurch ausgebaut werden kann. Es ist insbesondere auch zu erkennen, daß die beiden Polschuhe 8 und 9 entgegengesetzter Polarität zwischen den gleichen Ebenen $E_1$ und $E_2$ liegen.

Fig. 7 zeigt wiederum eine analoge Anordnung, und zwar gleichfalls mit negativer Überlappung «d». Hier wurde jedoch eine Änderung am Magnetsystem 2 vorgenommen, und zwar wurde die Lage des Magnetjochs und der Permanentmagnete vertauscht. In diesem Fall liegt nämlich kein durchgehendes Magnetjoch vor, sondern an dessen Stelle ist ein Permanentmagnet 23 getreten, der nach Maßgabe des Pfeils radial magnetisiert ist. Die Polflächen stehen mit einem zylindrischen, ferromagnetischen Kern 24 sowie mit einem ferromagnetischen Hohlzylinder 25 in Verbindung, an deren oberen Stirnflächen die Magnetpole 4a bzw. 3a gebildet werden. Der Verlauf des magnetischen Flusses ist dabei im wesentlichen der gleiche wie bei den vorangegangenen Ausführungsformen, jedoch ist die Anordnung des Permanentmagnets 23 oder – bei einer langgestreckten Anordnung der Permanentmagnete – einfacher gestaltet. Es sind auch Ausführungen denkbar, in denen das Magnetsystem 2 aus einem Stück eines hartmagnetischen Werkstoffes besteht, das in geeigneter Weise magnetisiert ist.

Mit den vorstehend beschriebenen Magnetronkatoden wurden Targets aus Eisen mit mittleren Zerstäubungsraten von etwa 9,0 nm/sec bei einer spezifischen elektrischen Leistung von 25 W/cm² zerstäubt. Die Targetabtragung war dabei über die gesamte Zerstäubungsfläche 7a außerordentlich gleichmäßig (vergleiche Fig. 10). Bei den Versuchen bestanden die Polschuhe und die Targets aus 10 mm dicken Weicheisenteilen, in denen der magnetische Fluß weit unterhalb der magnetischen Sättigung lag. Die Zerstäubungsatmosphäre bestand aus Argon mit einem Druck zwischen $8 \times 10^{-4}$ und $10^{-2}$ mbar. Weitere mögliche Werkstoffe sind z.B.: Permalloy, CoCr-Legierung (z.B. 80/20).

In Fig. 8 sind gleiche Teile oder Teile mit gleichen Funktionen mit den gleichen Bezugszeichen wie bisher versehen. In dem hier dargestellten Fall ist der Katodengrundkörper 1 nicht mit dem Magnetjoch identisch, sondern als zusätzlicher Hohlkörper ausgebildet, und durch den Metallkörper 16 verschlossen, der hier als planparallele Platte aus einem amagnetischen Werkstoff (Kupfer) ausgeführt ist. Die Abdichtung gegenüber dem Katodengrundkörper 1 wird durch nicht näher bezeichnete Rundschnurdichtungen und Zugschrauben 27 und 28 bewirkt. Zwischen dem Metallkörper 16 und dem Katodengrundkörper 1 befindet sich ein Kühlmittelkanal 17, in dem die Permanentmagnete 3 und 4 sowie das Magnetjoch untergebracht sind. Die Befestigung erfolgt über Isolierkörper 27 und Zugschrauben 28.

Auf der ebenen Außenseite des Metallkörpers 16 sind das ringförmig geschlossene Target 7 sowie der zentrale Polschuh 9 und die peripheren Polschuhe 8 angeordnet. Um hierbei die beiden Luftspalte 12 und 13, die dem Verlauf der Targetränder folgen, in Tiefenrichtung des Magnetrons zu erhalten, sind die Polschuhe 8 und 9 auf Distanzstücken 29 und 30 befestigt, die eine Höhe aufweisen, die um die Breite der Luftspalte 12 und 13 größer ist als die Dicke des Targets 7. Da hierdurch der Abstand zwischen den Polschuhen 8 und 9 und den zugehörigen Magnetpolen der Permanentmagnete 3 und 4 wächst, wird der Abstand zwischen der Oberseite des Metallkörpers 16 und der Unterseite der Polschuhe 8 und 9 durch ferromagnetische Körper 34 und 35 überbrückt, die innerhalb der aus amagnetischem Werkstoff bestehenden Distanzstücke 29 und 30 angeordnet sind. Die äußeren Körper 34 und die inneren Körper 35 sind im Falle von Rechteckkatoden als Leisten ausgeführt, deren Verlauf dem Verlauf der Polschuhe 8 folgt.

Es ist Fig. 8 zu entnehmen, daß der Abstand «S» sich aus der Dicke des Metallkörpers 16 und aus dem Abstand zusammensetzt, der zwischen den Magnetpolen und der Innenseite des Metallkörpers 16 besteht. Wie bereits weiter oben ausgeführt wurde, ist die Einhaltung eines solchen Abstandes, der einen magnetischen Widerstand von beträchtlicher Größe darstellt, im Hinblick auf die Flußverteilung zwischen dem Target 7 einerseits und den Polschuhen 8 und 9 andererseits wichtig.

Fig. 8 ist zu entnehmen, daß die Projektionen der Permanentmagnete 3 und 4 und der ferromagnetischen Körper 34 und 35 auf eine gemeinsame, zur Targetfläche 7a parallele Ebene, nicht kongruent sein müssen. Vielmehr ist – wie gezeigt – ein erheblicher seitlicher Versatz möglich. Auch hierdurch lassen sich die relativen Anteile des in das Target 7 einerseits und in die Polschuhe 8 bzw. 9 andererseits eintretenden magnetischen Flusses verändern, wobei ein magnetischer Kurzschluß zwischen den ferromagnetischen Körpern 34 und 35 und dem Target 7 unter allen Umständen verhindert werden muß. Aus diesem Grunde befindet sich zwischen den ferromagnetischen Körpern 34 und 35 und dem Target 7 auch jeweils noch ein entsprechender Abschnitt der aus amagnetischem Werkstoff bestehenden Distanzstücke 29 und 30.

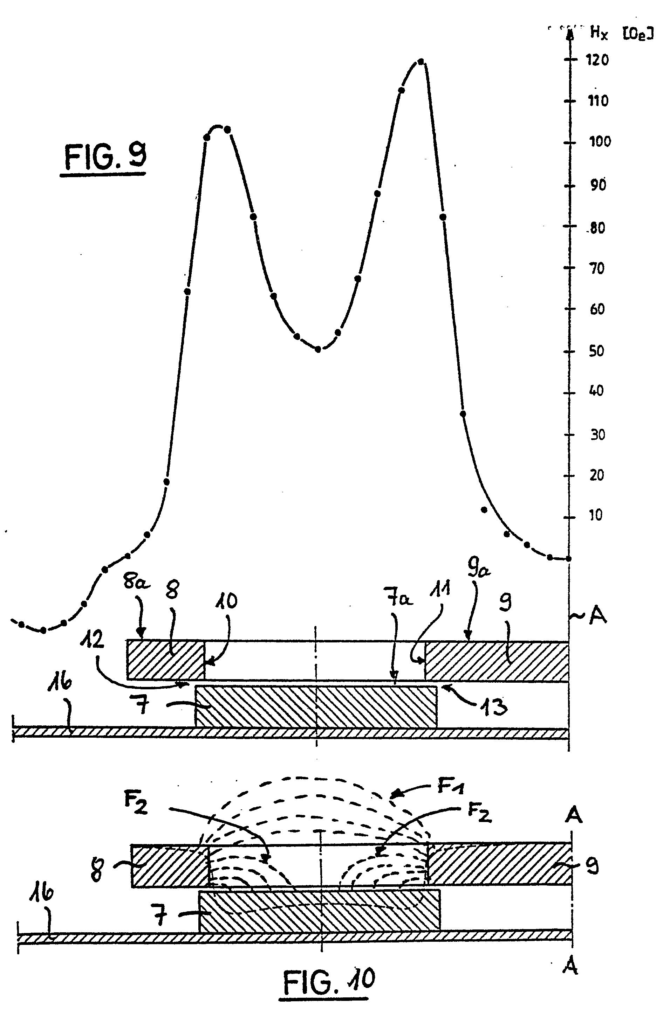

In Fig. 9 sind aus Fig. 8 nur noch das Target 7 und die Polschuhe 8 bzw. 9 oberhalb des ebenen Metallkörpers 16 dargestellt, und auch die Lage der Luftspalte 12 und 13 ist in Relation zur Zerstäubungsfläche 7a erkennbar. Die Achse des Magnetrons ist mit «A» bezeichnet, d.h. es sind nur die Teile eines halben Magnetrons dargestellt.

Unter exakter radialer Zuordnung zur Achse A ist im oberen Teil von Fig. 9 der Verlauf der Horizontalkomponente $H_x$ der magnetischen Feldstärke aufgetragen, und zwar handelt es sich um die Feldstärke im Abstand von 2 mm über der Polschuhoberfläche 8a bzw. 9a. Es ist zu erkennen, daß die Horizontalkomponente im Bereich der Austrittsflächen 10 und 11 je ein Maximum aufweist. Zwischen den Maxima geht die Kurve jedoch keineswegs durch Null, sondern selbst an der Stelle des Minimums, das über der Mitte des Targetquerschnitts liegt, ist noch eine erhebliche Horizontalkomponente vorhanden. Der zwischen den beiden Maxima liegende Verlauf der Kurve ist ein Beweis für die Existenz einer das Target 7 übergreifenden «Brücke» aus magnetischen Feldlinien $F_1$, die zusätzlich zu den unmittelbar in das Target 7 eintretenden Feldlinien $F_2$ vorhanden sind (Fig. 10). Diese Brücke ist mit dem bei den bisher bekannten planaren Magnetrons vorhandenen «magnetischen Tunnel» vergleichbar. Hierdurch ist ein effektiver Plasmaeinschuß im gesamten Targetbereich gewährleistet, was zu dem beobachteten, extrem flachen Erosionsprofil führt (vergleiche Fig. 10).

Es ist hervorzuheben, daß auch bei der Anordnung gemäß Fig. 9 die ferromagnetischen Körper 34 und 35 vorhanden sind. Versuche, die unter Weglassung der äußeren ferromagnetischen Körper 34 durchgeführt worden sind, zeigen nicht das gleiche günstige Ergebnis wie die Versuche mit einer Anordnung gemäß Fig. 8. Durch die äußeren ferromagnetischen Körper 34 wurde jedenfalls das Magnetfeld insbesondere in der Mitte des Targetquerschnitts und am äußeren Targetrand deutlich verstärkt, so daß sich eine gleichmäßigere Abtragung des Targetmaterials ergab. Dies äußerte sich auch bei der optischen Beobachtung des Plasmas, das bei einem Druck von $5 \times 10^{-3}$ mbar fast homogen über die gesamte Targetbreite verteilt war. Bezogen auf die Zerstäubungsfläche 7a wurde eine spezifische Zerstäubungsleistung von 22,0 W cm$^{-2}$ im Dauerbetrieb aufrecht erhalten.

In Fig. 10 sind die gleichen Vorrichtungsteile wie in Fig. 9 schraffiert dargestellt, und zwar vor Beginn des ersten Zerstäubungsvorganges. Die gestrichelt eingezeichnete Linie zeigt die Lage der Oberflächen der Polschuhe 8 und 9 einerseits und des Targets 7 andererseits, nachdem die Magnetronkatode für die Dauer von insgesamt 82 Stunden im Einsatz gewesen ist. Es zeigt sich, daß die Ausnutzung des Targetwerkstoffs nahezu über den gesamten Targetquerschnitt überdurchschnittlich gleichmäßig ist und daß es insbesondere nicht zu den gefürchteten V-förmigen Erosionsgräben gekommen ist, wie sie sich selbst beim Zerstäuben von nicht-ferromagnetischen Werkstoffen einstellen. Dieser Vorgang ist um so bemerkenswerter, als hier keine zusätzlichen Hilfsmittel für die mechanische oder elektrische Bewegung des Magnetfeldes vorhanden sind.

Fig. 11 zeigt eine typische Magnetronkennlinie, wie sie beim Betrieb des Magnetrons nach Fig. 8 bei einem Argon Druck von $5 \times 10^{-3}$ mbar erhal-

ten wurde. Ab einem Spannungswert von etwa 400 V ließ sich der Katodenstrom I durch eine relativ geringe Spannungserhöhung in linearer Abhängigkeit beträchtlich steigern, was für den Betrieb von Planarmagnetrons mit nicht-ferromagnetischen Targets üblich ist. Der Endpunkt der gezeigten Kennlinie entspricht einer mittleren Leistungsdichte am Target von 22 W cm$^{-2}$.

**Patentansprüche**

1. Magnetronkatode zum Zerstäuben ferromagnetischer Targets (7), bestehend aus einem Katodengrundkörper (1) mit einem Magnetsystem (2) mit einem Joch (5) und auf diesem angeordneten, jeweils entlang einer geschlossenen Umfangslinie eine Poleinheit bildenden Magnetpolen (3a, 4a) entgegengesetzter Polarität, wobei die Projektion in eine gemeinsame Ebene der inneren Umfangslinie des außenliegenden Magnetpols (3a) die Projektion der äußeren Umfangslinie des innenliegenden Magnetpols (4a) einschließt, ferner den Magnetpolen (3a, 4a) mindestens teilweise aus Targetmaterial bestehende Polschuhe (8, 9) mit dem Verlauf der Magnetpole ähnlichen Austrittsflächen (10, 11) zugeordnet sind, wobei ferner im Raum zwischen den Polschuhen (8, 9) und dem Joch (5) unter Belassung zweier umlaufender Luftspalte (12, 13) ein auf dem Umfang zusammenhängendes Target (7) aus ferromagnetischem Metall mit einer Zerstäubungsfläche (7a) angeordnet ist, und wobei Magnetpole (3a, 4a) und Target (7) sich hinsichtlich ihrer Projektionsflächen in einer zur Zerstäubungsfläche (7a) parallelen Ebene nicht überschneiden, und die Polschuhe (8, 9) und das Target (7) elektrisch leitend miteinander verbunden sind, dadurch gekennzeichnet, daß die Polschuhe (8, 9) durch je einen Abstand (s), in dem sich ein nicht ferromagnetisches Medium befindet, von den Magnetpolen (3a, 4a) getrennt sind, daß die Magnetpole (3a, 4a) in einem Bereich liegen, der sich von einer durch die Zerstäubungsfläche (7a) des Targets (7) gehenden Ebene in Richtung auf die Basis des Jochs (5) erstreckt und daß zwischen den Polschuhen (8, 9) und dem Target (7) einerseits und den Magnetpolen (3a, 4a) andererseits ein wärmeleitender Metallkörper (16) angeordnet ist, der mit mindestens einem Kühlmittelkanal (17) in Verbindung steht und aus einem nicht ferromagnetischen Werkstoff besteht.

2. Magnetronkatode nach Anspruch 1, dadurch gekennzeichnet, daß die dem Target (7) zugekehrten Flächen der Polschuhe (8, 9) eben sind.

3. Magnetronkatode nach Anspruch 1, dadurch gekennzeichnet, daß die Austrittsflächen (10, 11) der Polschuhe im wesentlichen senkrecht zur Zerstäubungsfläche (7a) ausgerichtet sind.

4. Magnetronkatode nach Anspruch 1, dadurch gekennzeichnet, daß die Projektionen der Austrittsflächen (10, 11) der Polschuhe (8, 9) und der umlaufenden Seitenflächen (7b, 7c) des Targets (7) in eine zur Zerstäubungsfläche parallele Ebene paarweise im wesentlichen kongruent sind (Fig. 1, rechts).

5. Magnetronkatode nach Anspruch 1, dadurch gekennzeichnet, daß die Projektionen der Austrittsflächen (10, 11) der Polschuhe (8, 9) und der umlaufenden Seitenflächen (7b, 7c) des Targets (7) in eine zur Zerstäubungsfläche parallele Ebene einen Abstand voneinander im Sinne einer Nicht-Überlappung aufweisen (Fig. 6 und 7).

6. Magnetronkatode nach Anspruch 1, dadurch gekennzeichnet, daß das Magnetsystem (2) einschließlich seines Magnetjoches (5) vom Target (7) und von den Polschuhen (8, 9) elektrisch isoliert ist.

7. Magnetronkatode nach Anspruch 1, dadurch gekennzeichnet, daß der Metallkörper (16) im Querschnitt mäanderförmig ausgebildet ist.

8. Magnetronkatode nach Anspruch 1, dadurch gekennzeichnet, daß zwischen den Polschuhen (8, 9) und dem wärmeleitenden Metallkörper (16) ferromagnetische Körper (34, 35) als Flußführungen eingesetzt sind.

**Claims**

1. A magnetron cathode for the sputtering of ferromagnetic targets (7), comprising a cathode main body (1) having a magnet system (2) with a yoke (5) and magnetic poles (3a, 4a) of opposite polarity disposed on said yoke and forming a respective pole unit along a closed circumferential line, wherein the projection into a common plane of the inner circumferential line of the external magnetic pole (3a) includes the projection of the outer circumferential line of the internal magnetic pole (4a), the magnetic poles (3a, 4a) having associated pole pieces (8, 9) which are made at least partially from target material and which have exit faces (10, 11) similar to the shape of the magnetic poles, and a target (7), continuous on the circumference, and made from ferromagnetic material and having a sputtering surface (7a), being disposed in the space between the pole pieces (8, 9) and the yoke to leave two continuous air gaps (12, 13), and wherein the magnetic poles (3a, 4a) and the target (7) do not intersect with respect to their surfaces of projection in a plane parallel to the sputtering surface (7a), and the pole pieces (8, 9) and the target (7) are interconnected in an electrically conductive manner, characterised in that the pole pieces (8, 9) are each separated from the magnetic poles (3a, 4a) by a space (s) in which a non-ferromagnetic medium is located, that the magnetic poles (3a, 4a) are located in a region which extends towards the base of the yoke (5) from a plane passing through the sputtering surface (7a) of the target (7), and that a thermally conductive metal body (16) is disposed between the pole pieces (8, 9) and the target (7) in the one hand and the magnetic poles (3a, 4a) on the other hand, and is connected to at least one coolant passage (17) and is made from a non-ferromagnetic material.

2. A magnetron cathode as claimed in claim 1, characterised in that those surfaces of the pole pieces (8, 9) which faces the target (7) are planar.

3. A magnetron cathode as claimed in claim 1, characterised in that the exit faces (10, 11) of the pole pieces are aligned substantially at right angles to the sputtering surface (7a).

4. A magnetron cathode as claimed in claim 1, characterised in that the projections of the exit faces (10, 11) of the pole pieces (8, 9) and of the continuous end faces (7b, 7c) of the target (7) are substantially congruent in pairs in a plane parallel to the sputtering surface (Figure 1, right).

5. A magnetron cathode as claimed in claim 1, characterised in that the projections of the exit faces (10, 11) of the pole pieces (8, 9) and of the continuous end faces (7b, 7c) of the target (7) are spaced apart in the sense of non-overlap in a plane parallel to the sputtering surface (Figures 6 and 7).

6. A magnetron cathode as claimed in claim 1, characterised in that the magnet system (2), including its magnet yoke (5), is electrically insulated from the target (7) and from the pole pieces (8, 9).

7. A magnetron cathode as claimed in claim 1, characterised in that the metal body (16) has a meander-shaped cross section.

8. A magnetron cathode as claimed in claim 1, characterised in that ferromagnetic bodies (34, 35) are inserted as flux guides between the pole pieces (8, 9) and the thermally conductive metal body (16).

**Revendications**

1. Cathode-magnétron pour la pulvérisation de cibles ferromagnétique (7), constituée d'un corps de cathode (1) avec un système magnétique (2), avec une culasse (5) et sur celle-ci, des pôles magnétiques (3a, 4a) de polarité opposée formant une unité polaire le long d'un périmètre continu, la projection sur un plan commun du périmètre intérieur du pôle magnétique extérieur (3a) incluant la projection du périmètre extérieur du pôle magnétique intérieur (4a), avec de plus des pièces polaires (8, 9) constituées au moins en partie du matériau de la cible et portant des surfaces de sortie (10, 11) dont la forme est similaire à celle des pôles magnétiques (3a, 4a), avec, dans l'espace entre les pièces polaires (8, 9) et la culasse (5), une cible (7) continue sur son périmètre, fabriquée en matériau ferromagnétique et présentant une surface de pulvérisation (7a), qui ménage deux entrefers (12, 13), où les projections des pôles magnétiques (3a, 4a) et de la cible (7) sur un plan parallèle à la surface de pulvérisation (7a) ne se recoupent pas et où les pièces polaires (8, 9) et la cible (7) sont reliées électriquement, caractérisée en ce que les pièces polaires (8, 9) sont séparées des pôles magnétiques (3a, 4a) par un écartement (s) dans lequel se trouve un milieu non ferromagnétique, en ce que les pôles magnétiques (3a, 4a) se trouvent à un niveau qui s'étend dans la direction de la base de la culasse (5) à partir d'un plans passant par la surface de pulvérisation (7a) de la cible (7) et en ce qu'il existe entre les pièces polaires (8, 9) et la cible (7) d'une part et les pôles magnétiques (3a, 4a) d'autre part un corps métallique (16) conducteur thermique qui est relié à au moins une gaine de fluide de refroidissement (17) et qui est fabriqué dans un matériau non ferromagnétique.

2. Cathode-magnétron selon la revendication 1, caractérisée en ce que les surfaces des pièces polaires (8, 9) tournées vers la cible (7) sont planes.

3. Cathode-magnétron selon la revendication 1, caractérisée en ce que les surfaces de sortie (10, 11) des pièces polaires sont essentiellement perpendiculaires à la surface de pulvérisation (7a).

4. Cathode-magnétron selon la revendication 1, caractérisée en ce que les projections des surfaces de sortie (10, 11) des pièces polaires (8, 9) et celles des faces latérales (7b, 7c) entourant la cible (7) sont congrues par paires dans un plan parallèle à la surface de pulvérisation (figure 1, à droite).

5. Cathode-magnétron selon la revendication 1, caractérisée en ce que les projections des surfaces de sortie (10, 11) des pièces polaires (8, 9) et celles des faces latérales (7b, 7c) entourant la cible (7) dans un plan parallèle à la surface de pulvérisation présentent un écartement correspondant à un non recouvrement (figures 6 et 7).

6. Cathode-magnétron selon la revendication 1, caractérisée en ce que le système magnétique (2), y compris la culasse (5), est isolé électriquement de la cible (7) et des pièces polaires (8, 9).

7. Cathode-magnétron selon la revendication 1, caractérisée en ce que le corps métallique (16) présente en coupe la forme d'un zig-zag.

8. Cathode-magnétron selon la revendication 1, caractérisée en ce que des corps ferromagnétiques (34, 35) servant de guides de flux magnétique sont placés entre les pièces polaires (8, 9) et le corps métallique (16) conducteur thermique.

## FIG. 1

## FIG. 4

FIG.2

FIG.3

FIG. 5

FIG. 6

FIG.7

FIG.8

FIG. 9

FIG. 10

FIG. 11